(19) Europäisches Patentamt / European Patent Office / Office européen des brevets

(11) **EP 3 553 541 B1**

(12) **EUROPEAN PATENT SPECIFICATION**

(45) Date of publication and mention
of the grant of the patent:
**02.09.2020 Bulletin 2020/36**

(51) Int Cl.:
***G01R 31/08*** *(2020.01)*

(21) Application number: **18167395.5**

(22) Date of filing: **13.04.2018**

(54) **DEVICE AND METHOD FOR LOCATING EARTH FAULTS IN ELECTRICAL DISTRIBUTION GRIDS**

VORRICHTUNG UND VERFAHREN ZUR ERDSCHLUSSORTUNG IN ELEKTRISCHEN VERTEILUNGSNETZEN

DISPOSITIF ET PROCÉDÉ PERMETTANT DE LOCALISER DES DÉFAUTS À LA TERRE DANS DES RÉSEAUX DE DISTRIBUTION ÉLECTRIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**16.10.2019 Bulletin 2019/42**

(73) Proprietor: **GridData GmbH**
**83454 Anger (DE)**

(72) Inventors:
• **SCHWEFEL, Hans-Peter**
  **85454 Anger (DE)**
• **SILVA, Nuno**
  **85454 Anger (DE)**

(74) Representative: **Patentree**
**Edificio Net**
**Rua de Salazares, 842**
**4149-002 Porto (PT)**

(56) References cited:
**CN-A- 104 111 434       CN-A- 106 856 322**
**US-A1- 2007 059 986    US-A1- 2016 041 216**
**US-A1- 2016 308 345**

• **BUI DUONG MINH ET AL: "Investigation on transient behaviours of a uni-grounded low-voltage AC microgrid and evaluation on its available fault protection methods: Review and proposals", RENEWABLE AND SUSTAINABLE ENERGY REVIEWS, vol. 75, 22 November 2016 (2016-11-22), - 22 November 2016 (2016-11-22), pages 1417-1452, XP029978445, ISSN: 1364-0321, DOI: 10.1016/J.RSER.2016.11.134**
• **BAHMANYAR A ET AL: "A comparison framework for distribution system outage and fault location methods", ELECTRIC POWER SYSTEMS RESEARCH, ELSEVIER, AMSTERDAM, NL, vol. 145, 28 December 2016 (2016-12-28), pages 19-34, XP029916788, ISSN: 0378-7796, DOI: 10.1016/J.EPSR.2016.12.018**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

### Technical field

The present disclosure relates to a device and method for automatically locating earth faults in electrical distribution grids, in particular for compensated electrical distribution grids, also known as resonant grounding, also known as neutral earthing with a Petersen Coil.

### Background

Locating earth faults in electrical distribution grids, as in electrical distribution grids in general, is essential to the operation of the electrical grid. With the localization of an occurring earth fault, technical teams can be dispatched to resolve the fault, normally by repairing a failed grid component or link. Obviously, visual inspection by human technicians is not sensible, given that an electrical distribution grid can encompass thousands of square kilometres and the time to repair the fault is critically important. Furthermore, compensated electrical distribution grids have specificities that hinder prior art localization methods.

Thus, there is a need for devices and methods for locating earth faults in electrical distribution grids, in particular in compensated electrical distribution grids also known as resonant grounding, also known as neutral earthing with a Petersen Coil.

Some prior art solutions rely on direction indicators that are deployed at different places in the electrical distribution grid. The directional information from pluralities of these indicators is then correlated to the grid topology in order to delimit the location of the Earth fault. Disadvantages include the need of deployment of multiple sensors in distributed places in the electrical distribution grid.

US2016041216 A1 discloses the detection and location a single-phase ground fault on a low current grounded power-distribution network, involving the reception of voltage and current signals at multiple positions on each phase feeder, and determining transient voltage and current signals therefrom.

Some prior art solutions rely on the measurement of impedance to fault by protection relays, however this approach cannot be applied to compensated grids. There may be solutions in which the compensation is temporarily disabled in order to allow for an impedance to fault measurement. This approach however would require additional electricity grid related equipment.

These facts are disclosed in order to illustrate the technical problem addressed by the present disclosure.

### General Description

The present disclosure relates to a device and method for automatically locating earth faults in electrical distribution grids, in particular for compensated electrical distribution grids, also known as resonant grounding, also known as neutral earthing with a Petersen Coil.

Advantages of the disclosure include:

The disclosed devices and methods can be applied to compensated electrical distribution grids;
Reduced time to localization, increased accuracy of localization and reduced cost for deployment;
No dedicated sensors need to be deployed in multiple geolocations of the electrical distribution grid;
The disclosed devices and methods can use measurements just at the primary substation;
The disclosed devices and methods use only passive measurement of the earth fault;
Additional measurements at other places in the electrical distribution grid can be optionally included for increased accuracy;
Accuracy of other prior art approaches are not yet shown to be sufficient in a large variety of electrical distribution grid scenarios; contrary to the disclosed devices and methods which are able to support a wide variety of electrical distribution grid;
May be implemented as a purely software based solution to locate Earth Faults in grids.

The disclosure has particular application in protection systems for electricity distribution grids and SCADA systems for electricity distribution grids.

It is disclosed a device according to claim 1 for locating earth faults in compensated electrical distribution grids, comprising an electronic data processor.

It has been surprisingly found that time-domain signals immediately ensuing the earth fault contain sufficient information to locate the earth fault in electrical distribution grids, even in large and complex compensated electrical distribution grids.

The present disclosure is also applicable to non-compensated electrical distribution grids, with the required adaptations, if necessary, within the reach of the skilled person in the field.

It is also disclosed a method according to claim 13 for locating earth faults in a compensated electrical distribution grid, comprising an electronic data processor.

In an embodiment, the time-domain captured voltage or current signal is a passively captured signal, in particular passively captured such that compensation of the compensated electrical distribution grid is maintained.

An embodiment comprises outputting the earth fault location corresponding to a weighted location calculated from two signature signals from said plurality of signature signals which have the two highest calculated correlations with the captured signal, wherein the weighting for calculating said weighted location is by the calculated correlations.

An embodiment comprises outputting the earth fault location corresponding to a weighted location calculated from two or more selected signature signals from said plurality of signature signals which are selected as having the highest calculated correlations with the captured signal, wherein the weighting for calculating said weighted location is by the calculated correlations.

In an embodiment, said database comprises a plurality of time-domain, voltage or current respectively, signature signals, wherein each signature signal is a time-domain signal corresponding to an earth fault location and an earth fault impedance value corresponding to a plurality of predetermined locations in said electrical distribution grid and a plurality of impedance earth fault values;

wherein the electronic data processor is further configured for outputting the earth fault location and earth fault impedance value corresponding to the signature signal from said plurality of signature signals which has the highest correlation with the captured signal.

The location of the electrical distribution grid is a substation of said electrical distribution grid, the substation being where the time-domain captured voltage or current signal was captured.

In an embodiment, the plurality of time-domain, voltage or current respectively, signature signals, comprise signature signals obtained by previously simulating said electrical distribution grid or simulating a part of said electrical distribution grid.

In an embodiment, the plurality of time-domain, voltage or current respectively, signature signals, comprise signature signals obtained by simulating said electrical distribution grid or a part of said electrical distribution grid, wherein the simulation is triggered by the earth fault detection signal.

In an embodiment, the plurality of time-domain, voltage or current respectively, signature signals, comprise signature signals obtained by previously capturing occurred earth faults of said electrical distribution grid, in particular experimentally induced or naturally occurring earth faults.

In an embodiment, the plurality of predetermined locations in said electrical distribution grid is predetermined according to electrical distribution grid nodes.

In an embodiment, the plurality of predetermined locations in said electrical distribution grid is predetermined according to equally distanced electrical distribution grid locations.

In an embodiment, the plurality of predetermined locations in said electrical distribution grid is predetermined according to randomly determined electrical distribution grid locations.

In an embodiment, the time-domain captured voltage or current signal is rescaled in the time-domain such that the phase of the captured signal matches the phase of the database signature signals.

In an embodiment, said time-domain has a duration of 0 - 25 ms ensuing the earth fault, in particular of 0 - 10 ms, further in particular of 0 - 5 ms, further in particular of 0 - 2 ms, further in particular of 0 - 1 ms.

In an embodiment, said time-domain capturing and correlating is carried out with a minimum of 1 ms resolution, in particular a minimum of 0.1 ms resolution.

In an embodiment, the correlation is a time-domain calculated correlation, in particular a time-domain similarity calculation or by a machine-learning algorithm, further in particular a square of the difference calculation or by an artificial-neural network.

An embodiment comprises an earth fault detector for providing the signal that an earth fault has occurred.

An embodiment comprises measurement system for capturing the time-domain captured voltage or current signal.

In an embodiment, the device is a SCADA device.

In an embodiment, time-domain signals are voltage signals.

It is also disclosed a non-transitory storage media including program instructions for implementing a method for locating earth faults in an electrical distribution grid, the program instructions including instructions executable to carry out the method of any of the disclosed embodiments.

**Brief Description of the Drawings**

The following figures provide preferred embodiments for illustrating the disclosure and should not be seen as limiting the scope of invention.

**Figure 1:** Schematic representation of the main modules of an embodiment of the disclosed device.

**Figure 2:** Photographic reproduction of computer generated image of a representation of an embodiment of an electrical distribution grid topology.

**Figure 3:** Photographic reproduction of computer generated image of a representation of an embodiment of a derived 'Simulink' simulation model.

**Figure 4:** Photographic reproduction of computer generated image of a representation of example signatures at different zoom levels (horizontally) for one Earth Fault occurring at Busbar 2 (i.e. close to the primary substation in the topology of Fig. 2); upper set of graphs shows voltage, lower shows currents.

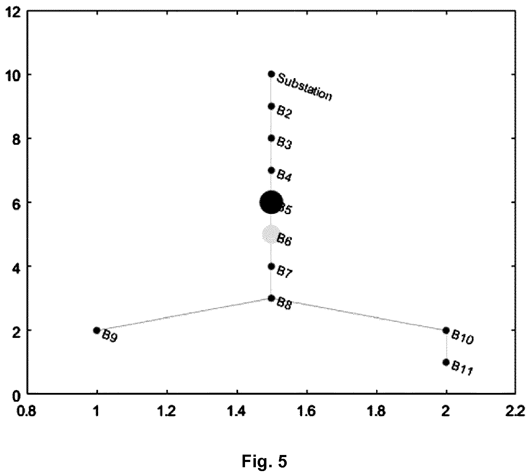

**Figure 5:** Schematic representation of an embodiment of an example of visualization; the darkest dot is the location from the signature database with the 'closest' signature, the lighter dot the second closest signature: this output would be interpreted as 'close to Busbar 5, and more likely on the line towards Busbar 6'.

**Figure 6:** Photographic reproduction of computer generated image of a representation of behaviour of voltages (top) and currents measured at primary substation when an Earth-Fault occurs at t=184ms at Busbar 11. The middle graph zooms into 4ms after the fault, the left graph zooms into 1.5ms after the fault.

**Figure 7:** Schematic representation of results of an embodiment of resulting similarity metrics for voltage compared with signatures at different bus-bars (x-axis) and for fault-impedances R=3 (black), R=10 (grey), R=50 (white). The upper graph compares the similarities for the faulty-phase, while the other graphs show the other phases.

**Figure 8:** Schematic representation of results of an embodiment of resulting similarity metrics for voltages compared with signatures at different bus-bars (x-axis) and for fault-impedances R=3 (black), R=10 (grey), R=50 (white). The true location of the fault is on the Line between Bus-Bars 6 and 7.

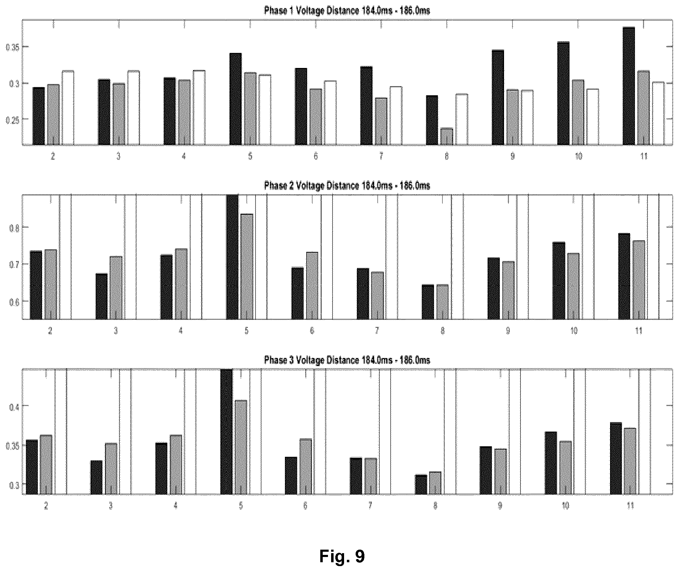

**Figure 9:** Schematic representation of results of an embodiment of similarities to signature database for an Earth Fault between Busbars 8 and 9 (impedance 2 $\Omega$).

**Figure 10:** Schematic representation of results of an embodiment of similarities to signature database for an Earth Fault between BB 8 and 10 (impedance 2 $\Omega$).

**Figure 11:** Schematic representation of results of an embodiment of repetition of the similarity calculation for the EF between BB 6 and 7 as in Figure 8, but now for a time interval of 5ms after the fault.

**Figure 12:** Schematic representation of results of an embodiment of repetition of the similarity calculation for the EF between BB 6 and 7 as in Figure 8, but now for a time interval of only 1ms after the fault.

**Detailed Description**

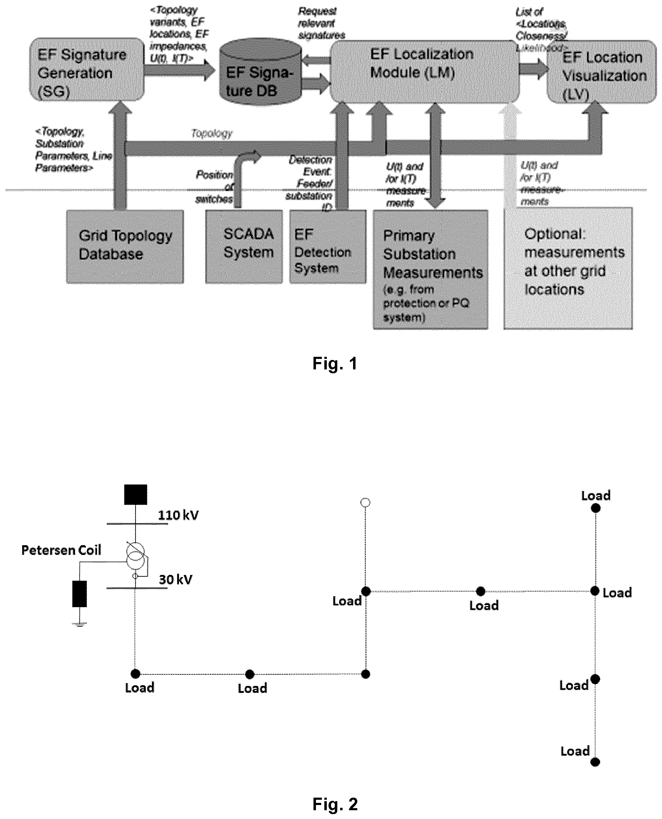

The localization solution in an embodiment of this disclosure includes of three software components: The Earth Fault Signature Generation (SG), the localization module - LM, and a location visualization function (LV). The localization module connects to an existing Earth Fault detection system. When the detection system notifies the localization module about the occurrence of an Earth Fault, the localization module obtains high-resolution (<1ms) voltage and/or current measurements from measurement points in the primary substation. These high-resolution measurements are compared to a set of 'signatures' from Earth Faults in different locations and with different Earth Fault Impedances. These signatures can be generated e.g. via simulation models, but also by using data from Earth Fault experiments or actual Earth Fault occurrences that have been previously localized and characterized by other means. The localization module calculates similarity metrics to the available basis of signatures and uses the similarity values to obtain likelihood of closeness of the Earth fault location to the known locations in the database. The location visualization function then visualizes the set of locations on top of the grid topology. See an embodiment in fig. 1.

The following describes in further detail the operation of the disclosed devices and methods.

In an embodiment, following input data is required for the disclosed devices and methods and corresponding existing electrical distribution grid systems, if this is the case, or with new systems being installed concurrently, as exemplified in the lower part of Figure 1:

- A description of the electrical distribution grid topology including the electrical parameters of the primary and secondary substations and of the distribution grid lines; such description is typically part of a topology database.

- The position of switches in the grid is required to obtain the actual grid topology at the moment the fault was occurring. The position of these switches is frequently contained in SCADA systems.

- A notification about the detection of an Earth Fault from a detection system (e.g. protection system). The notification is needed in order to obtain an accurate time stamp (preferably, an accuracy about 1ms or better) and, for example, the primary substation id or even the feeder on which the earth fault is detected.

- A measurement system that provides high-resolution voltage and/or current measurements from the primary substation. Examples of these measurement systems include currently deployed protection systems or Power Quality (PQ) measurement systems. Typically these can also be implemented to include a suitable data processor, e.g. a computer device, with corresponding computer program or programs. In particular, these systems may also incorporate the methods of the disclosure, as any other hardware device from the electrical distribution grid control and management equipment which is suitable to carry out said disclosed methods.

The Signature Generation component can either be run offline beforehand or as an alternative, the generation of signatures can also be triggered by the localization module component (so that only signatures or the specific relevant grid part and position of switches are generated). The Signature Generation component may use a grid simulation model or the generation of the signatures or it can obtain the signatures from a database of previously obtained measurements during fault experiments or life faults.

The localization module component preferably needs to be connected to the required data sources (for grid topology, position of switches and V(t) or I(t) measurements from the primary substation - optionally also to other V(t) or I(t) measurement sources).

For each signature s_i provided by the signature database, the localization module function calculates a similarity between the signature - appropriately normalized to account for the time T (or AC phase shift) at which the fault is occurring), n(s_i, T), and the actually measured voltage and/or current pattern, m(t) on each phase j: d_i,j=similarity(n(s_i(t,j),T), m(t,j))

The resulting vectors of similarity values are then preferably ranked according to a ranking criterion, which can be for instance:

Only faulty phase: use the similarity of the faulty-phase first
Weighted sum
Etc.

The resulting scalar similarity values are then preferably either used for ranking or by scaling to a [0,1] range as indicators of probability of being close to the true fault location.

Alternative similarity calculations can be made using artificial intelligence methods, such as machine-learning algorithms like ANNs, artificial networks. More generally, the signals can be compared for similarity using correlation measures and techniques, optionally time-domain rescaling. Correlation can be defined as a measure of relationship or the degree of association between variables, or in the present case, between two signals.

The solution is advantageously purely software based as the disclosed methods are adequate to be executed using general computer equipment; with the proviso that the necessary interfaces to the existing systems, if this is the case, or alternatively new systems being installed, may in some cases require some hardware support. Alternatively, the disclosed methods may be implemented in hardware or firmware - depending on the application. Obviously, the required systems to obtain electrical grid measurements require suitable hardware.

One possible embodiment uses simulations for signature creation, as described in the following steps:

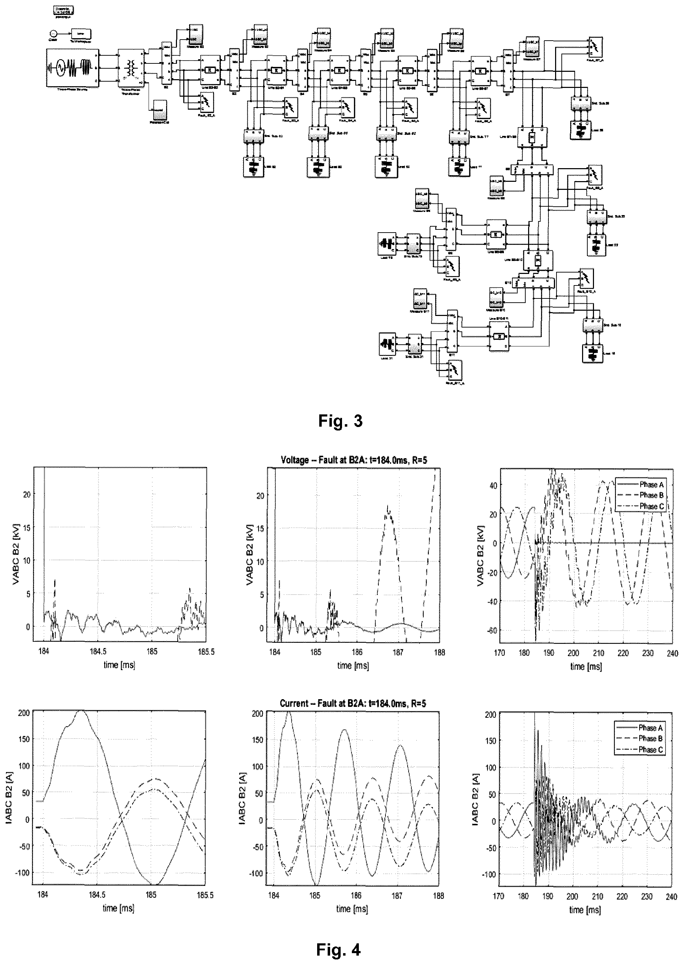

Step 1 - Translation of the grid topology and grid parameters into a simulation model, e.g. as exemplified below in figures 2 and 3.

Step 2 - The simulation model is used in the SG component to generate functions U(t) and/or I(t) for different Earth Fault locations and different Earth Fault Impedances, see below for one example figure 4.

Concurrent to what was explained above, Steps 1 and 2 can be done offline beforehand.

Step 3 - Localization module: Comparison of the voltage and or current measurements just after the fault with the Data Base.

Step 4 - Localization module: Calculation of the similarity values for all available signatures.

Step 5 - Visualization of the closest places from the Signature Database and indication of the similarity metric (i.e. the 'probability of being close to the true fault location) via a color code, as shown in the example below.

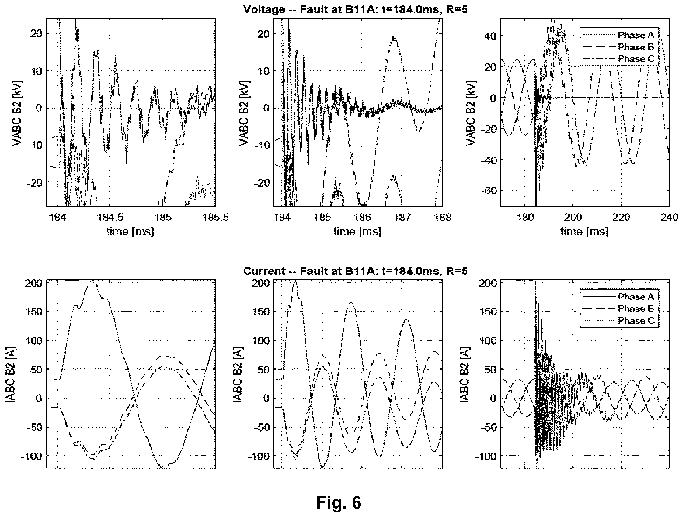

Figure 4 visualized an example signature of an Earth Fault close to the primary substation, in this case occurring at Bus-Bar 2 in the grid topology of Figure 2 and 3. In comparison to that, the signature of a fault at Bus-Bar 11, far away from the primary substation is shown subsequently in Figure 6. The comparison of Figure 4 and Figure 6 clearly shows the differences of the behaviour, both of voltages and currents. As the differences are more pronounced on voltages, the subsequent examples use the voltage curves only.

In order to show that these signatures (voltage and current curves) can really be used to localize an Earth Fault, a signature Database has been created by using the simulator with faults of impedances R=3, 10, and 50 Ohms for each bus-bar B2,...,B11 (so the signature DB contains in the given example 30 voltage and current curves; note the data from Figure 4 and Figure 6 is NOT contained among these 30 due to the different fault impedance). The same simulator is now used to create test-data for the localization algorithm. Then the similarity metrics of the resulting voltage and current curves to all re-scaled signatures in the database are shown in order to illustrate the localization capabilities of the proposed approach. The scaling of the signature curves thereby uses the ratio of the value of voltage or current just before the fault in the test-data to the analogue value in the compared signature. Initially, an interval of 2ms after the fault is used to calculate the similarity metric, and the similarity metric is the normalized integral over the absolute value of the differences of the test data curve and the re-scaled signature curve in comparison. The presented results focus on the similarity metrics of the voltage measurement; similar results are obtained for electrical current measurements.

The following examples are for the purpose of illustrating the disclosure and should not be seen as limiting the scope of the attached claims.

Example 1 Test-data created from Earth-Fault at Bus-bar

In this example, we use the resulting voltage curve for an Earth Fault at Busbar 2 with fault-impedance R=5. Note that there is no exact match in the signature database, as the impedances there are 3, 10, and 50 Ohms.

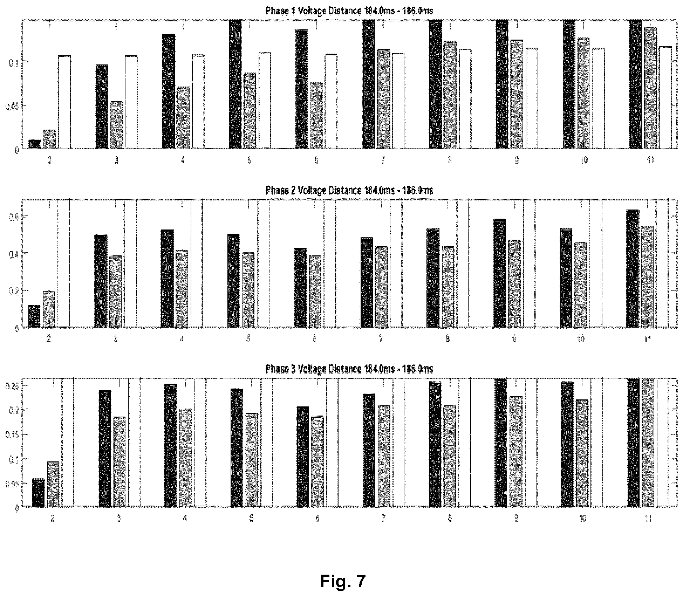

Figure 7 shows the resulting similarity values. The minimum value, and hence most similar curve, results for all three phases for bus-bar 2, which is also the true location of the fault. A change of the parameters of the loads thereby has only very minor impact on the resulting similarity values, so is therefore omitted here.

Example 2: Earth-Fault on one of the lines beween Busbars

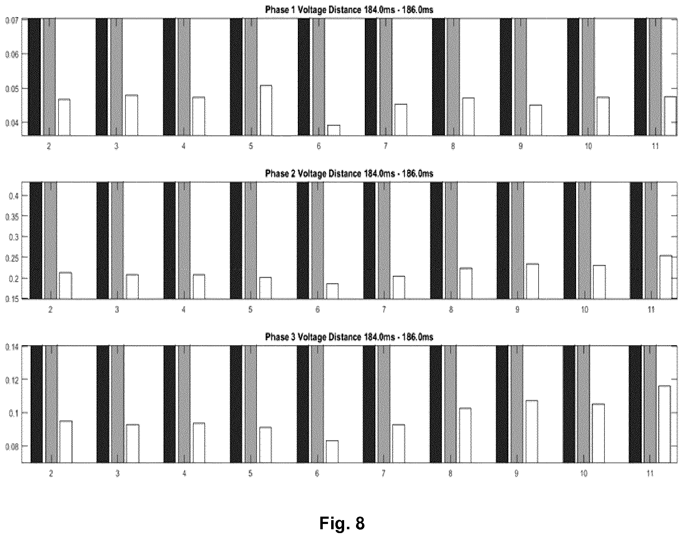

Figure 8 shows the result when comparing the differences to the signature DB for a fault location on the Line between Bus-Bar 6 and 7, for a fault of 45 Ohms, and for small loads. All three phases show a minimum for the signatures with 50 Ohms and fault locations at Bus-bar 6. The similarities of the faulty phase (top graph) also allow to infer that the fault is more likely away from Bus Bar 6 (as Bus Bar 7 shows a lower metric than Bus Bar 5), while the other phases are less conclusive here.

Example 3 - Test-data created from Earth-Faults in different segments but at same distance to primary substation

The following example uses Earth Faults injected in different branches at same distance to the primary substation, i.e. in the topology of Figure 2:

on the line between Busbar 8 and Busbar 9, 230 meters away from Busbar 8 (and as consequence 30 meters away from Busbar 9)
on the line between Busbar 8 and Busbar 10, 230 meters away from Busbar 8 (and as consequence 73 meters away from Busbar 10)

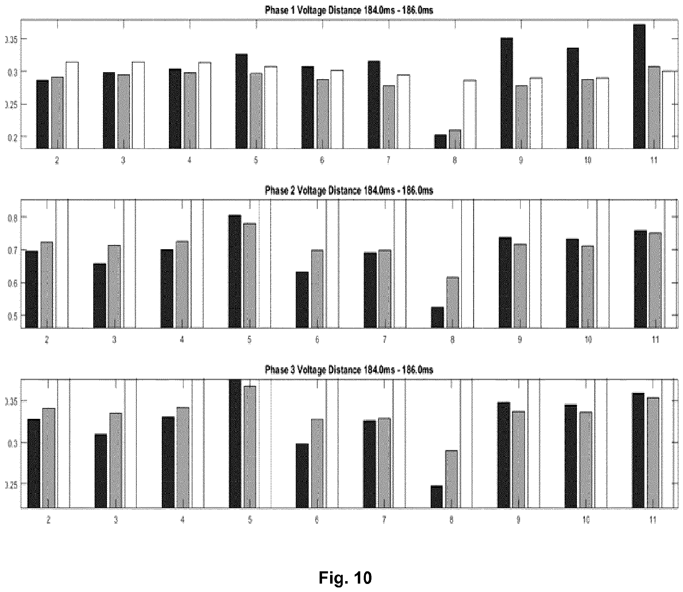

Fault-impedance is 2 Ohms in both cases. The inspection of Figure 8 and Figure 10 shows that Busbar 8 is in both cases identified as the 'closest' busbar, but the approach cannot identify Busbar 9 respectively 10 as the next closest. Since line characteristics of the Line BB8-BB9 are the same as line characteristics on BB8-BB10, it is actually physically impossible to identify, on which of the two branches the fault is occurring, but can identify that the location is contained in one of the two branches.

Example 4: Choice of time interval length for similarity calculation

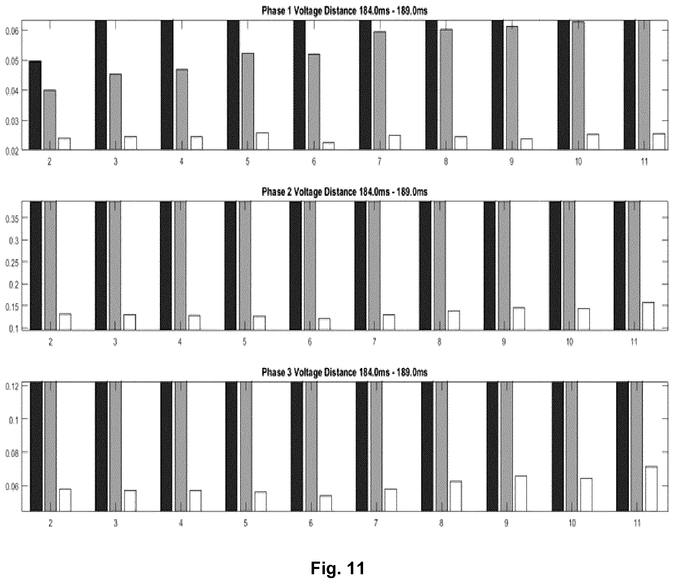

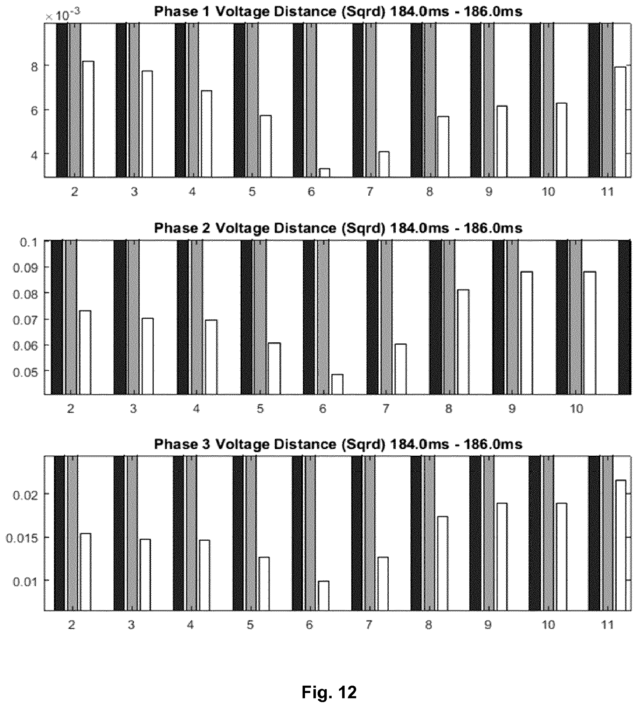

Figure 11 and 12 show two variants of localizing the fault between BB 6 and 7 (as already done in Figure 8), in which the localization uses time-intervals of different length just after the fault for the calculation of the similarity metric to the signature database: Fig 8 had used 2ms, Fig 11 uses a longer time window of 5ms, and Fig 12 a shorter time window of 1ms.

Comparing the three different cases shows that the approach works in all three cases to identify BB6 as the most fault location with most similar signature. So within the considered range of 1ms...5ms, the approach is rather robust. A too long time interval will however blur out the differences.

Example 5: Robustness to choice of similarity metric

The results shown so far use as similarity metric of two functions f(t), g(t), the integral over the absolute value of the difference of the two functions over the time window (of size mostly S=2ms) just after the fault:

$$ \text{sim}(f(t),g(t)) \; := \; 1/S \int_0^S |f(t) - g(t)| \; dt. $$

Note that a smaller value of sim(f(t),g(t)) indicates a stronger similarity.

In order to investigate the impact of the specific choice of this metric, the result of Fig. 8 is repeated using the squared value of the difference of the two functions:

$$ \text{sim2}(f(t),g(t)) \; := \; 1/S \int_0^S \big(f(t) - g(t)\big)^2 \; dt. $$

Figure 12 shows that the choice sim2 for the similarity metric, as the squared difference between the two curves, keeps the minimum at BB6 and even shows a clearer result on the faulty-phase for the second lowest value at BB7. Hence this choice of the similarity metric clearly shows the fault-location between BB6 and BB7. Again, the disclosed approach is rather robust, even if a similarity metric, as the squared difference between the two curves, provides improved results.

The previous examples establish that the disclosed methods and devices are robust and work well over multiple similarity measures, time scales, voltage or current measurements,

The term "comprising" whenever used in this document is intended to indicate the presence of stated features, integers, steps, components, but not to preclude the presence or addition of one or more other features, integers, steps, components or groups thereof.

It will be appreciated by those of ordinary skill in the art that unless otherwise indicated herein, the particular sequence of steps described is illustrative only and can be varied without departing from the disclosure. Thus, unless otherwise stated the steps described are so unordered meaning that, when possible, the steps can be performed in any convenient or desirable order.

It is to be appreciated that certain embodiments of the disclosure as described herein may be incorporated as code (e.g., a software algorithm or program) residing in firmware and/or on computer useable medium having control logic for enabling execution on a computer system having a computer processor, such as any of the servers described herein. Such a computer system typically includes memory storage configured to provide output from execution of the code which configures a processor in accordance with the execution. The code can be arranged as firmware or software, and can be organized as a set of modules, including the various modules and algorithms described herein, such as discrete code modules, function calls, procedure calls or objects in an object-oriented programming environment. If implemented using modules, the code can comprise a single module or a plurality of modules that operate in cooperation with one another to configure the machine in which it is executed to perform the associated functions, as described herein.

The disclosure should not be seen in any way restricted to the embodiments described and a person with ordinary skill in the art will foresee many possibilities to modifications thereof. The above described embodiments are combinable. The following claims further set out particular embodiments of the disclosure.

**Claims**

1.  Device for locating earth faults in a compensated electrical distribution grid comprising an electronic data processor configured for:

waiting until an earth fault detection signal that an earth fault has occurred;
obtaining a time-domain captured voltage or current signal wherein said time-domain comprises a time period ensuing said earth fault;
calculating the correlation of said time-domain captured signal with a database comprising a plurality of time-domain, voltage or current respectively, signature signals, wherein each signature signal is a time-domain signal corresponding to an earth fault location from a plurality of predetermined locations in said electrical distribution grid;
outputting the earth fault location corresponding the signature signal from said plurality of signature signals which has the highest correlation with the captured signal;
**characterized in that** the time-domain captured voltage or current signal is obtained at only one operational location of the electrical distribution grid; **and in that** the operational location of the electrical distribution grid is a substation of said electrical distribution grid, the substation being where the time-domain captured voltage or current signal is captured.

2. Device according to the previous claim wherein the time-domain captured voltage or current signal is a passively captured signal, in particular passively captured such that compensation of the compensated electrical distribution grid is maintained.

3. Device according to any of the previous claims comprising outputting the earth fault location corresponding to a weighted location calculated from two signature signals from said plurality of signature signals which have the two highest calculated correlations with the captured signal, wherein the location weighting is by the calculated correlations.

4. Device according to any of the previous claims wherein said database comprises a plurality of time-domain, voltage or current respectively, signature signals, wherein each signature signal is a time-domain signal corresponding to an earth fault location and an earth fault impedance value corresponding to a plurality of predetermined locations in said electrical distribution grid and a plurality of impedance earth fault values;
wherein the electronic data processor is further configured for outputting the earth fault location and the earth fault impedance value corresponding to the signature signal from said plurality of signature signals which has the highest correlation with the captured signal.

5. Device according to any of the previous claims wherein the plurality of time-domain, voltage or current respectively, signature signals, comprise signature signals obtained by previously simulating said electrical distribution grid or simulating a part of said electrical distribution grid.

6. Device according to any of the previous claims wherein the plurality of time-domain, voltage or current respectively, signature signals, comprise signature signals obtained by simulating said electrical distribution grid or a part of said electrical distribution grid, wherein the simulation is triggered by the earth fault detection signal.

7. Device according to any of the previous claims wherein the plurality of time-domain, voltage or current respectively, signature signals, comprise signature signals obtained by previously capturing occurred earth faults of said electrical distribution grid, in particular experimentally induced or naturally occurring earth faults.

8. Device according to any of the previous claims wherein the plurality of predetermined locations in said electrical distribution grid is predetermined according to electrical distribution grid nodes, or wherein the plurality of predetermined locations in said electrical distribution grid is predetermined according to equally distanced electrical distribution grid locations, or wherein the plurality of predetermined locations in said electrical distribution grid is predetermined according to randomly determined electrical distribution grid locations.

9. Device according to any of the previous claims wherein the time-domain captured voltage or current signal is rescaled in the time-domain, in particular such that the phase of the captured signal matches the phase of the database signature signals.

10. Device according to any of the previous claims wherein said time-domain has a duration of 0 - 25 ms ensuing the earth fault, in particular of 0 - 10 ms, further in particular of 0 - 5 ms, further in particular of 0 - 2 ms, further in particular of 0 - 1 ms, and/or wherein said time-domain capturing and correlating is carried out with a minimum of 1 ms resolution, in particular a minimum of 0.1 ms resolution.

11. Device according to any of the previous claims wherein the correlation is a time-domain calculated correlation, in particular time-domain similarity calculation or by a machine-learning algorithm, further in particular a square difference calculation or by an artificial-neural network.

12. Device according to any of the previous claims wherein time-domain signals are voltage signals.

13. Method for locating earth faults in a compensated electrical distribution grid comprising an electronic data processor carrying out the steps of:

waiting until an earth fault detection signal that an earth fault has occurred;
obtaining a time-domain captured voltage or current signal wherein said time-domain comprises a time period ensuing said earth fault;
calculating the correlation of said time-domain captured signal with a database comprising a plurality of time-domain, voltage or current respectively, signature signals, wherein each signature signal is a time-domain signal corresponding to an earth fault location from a plurality of predetermined locations in said electrical distribution grid;
outputting the earth fault location corresponding the signature signal from said plurality of signature signals which has the highest correlation with the captured signal;
**characterized in that** the time-domain captured voltage or current signal is obtained at only one operational location of the electrical distribution grid; **and in that** the operational location of the electrical distribution grid is a substation of said electrical distribution grid, the substation being where the time-domain captured voltage or current signal is captured.

14. Method according to the previous claims wherein the time-domain captured voltage or current signal is rescaled in the time-domain, in particular such that the phase of the captured signal matches the phase of the database signature signals.

15. Non-transitory storage media including program instructions for implementing a method for locating earth faults in an electrical distribution grid, the program instructions including instructions which, when executed by a processor, cause the processor to carry out the method of the claims 13 or 14.

**Patentansprüche**

1. Vorrichtung zur Erdschlussortung in einem kompensiert betriebenen elektrischen Verteilungsnetz mit einem elektronischen Datenprozessor, der so konfiguriert ist, um:

auf das Auftreten eines Fehlersignals eines Erdschlusses, das einen Erdschluss anzeigt, zu warten;
ein in einem Zeitbereich erfasstes Spannungs- oder Stromsignal zu empfangen, wobei der genannte Zeitbereich einen auf den Erdschluss folgenden Zeitraum umfasst;
eine Korrelation zwischen dem im Zeitbereich erfassten genannten Signal und einer Datenbank mit einer Vielzahl von Zeitbereichs-, Spannungs- bzw. Stromsignatursignalen zu berechnen, wobei jedes Signatursignal ein Zeitbereichssignal ist, das einer Erdschlussstelle in einer Vielzahl von im Voraus bestimmten Stellen in dem elektrischen Verteilungsnetz entspricht;
den Ort der Erdschlussstelle auszugeben, die dem Signatursignal aus der Vielzahl der Signatursignale entspricht, das die größte Korrelation mit dem erfassten Signal aufweist;
**dadurch gekennzeichnet, dass** das im Zeitbereich erfasste Spannungs- oder Stromsignal an nur einem Betriebsort des elektrischen Verteilungsnetzes erfasst wird; **und dass** der Betriebsort des elektrischen Verteilungsnetzes eine Unterstation des genannten elektrischen Verteilungsnetzes ist, wobei sich die Unterstation an dem Ort befindet, an dem das im Zeitbereich erfasste Spannungs- oder Stromsignal erfasst wird.

2. Vorrichtung nach dem vorangehenden Anspruch, bei der das im Zeitbereich erfasste Spannungs- oder Stromsignal ein passiv erfasstes Signal ist, insbesondere so passiv erfasst, dass die Kompensation des kompensiert betriebenen elektrischen Verteilungsnetzes aufrechterhalten wird.

3. Vorrichtung nach einem der vorangehenden Ansprüche, umfassend die Ausgabe der Erdschlussstelle, die einer gewichteten Stelle entspricht, die aus zwei Signatursignalen der genannten Vielzahl von Signatursignalen berechnet wird, welche die beiden größten berechneten Korrelationen mit dem erfassten Signal aufweisen, wobei die Ortsgewichtung anhand der berechneten Korrelationen erfolgt.

4. Vorrichtung nach einem der vorangehenden Ansprüche, wobei die Datenbank eine Vielzahl von Zeitbereichs-, Spannungs- bzw. Stromsignatursignalen umfasst, wobei jedes Signatursignal ein Zeitbereichssignal ist, das einer Erdschlussstelle und einem Wert der Impedanz eines Erdschlusses entspricht, die einer Vielzahl von im Voraus festgelegten Stellen in dem genannten elektrischen Verteilungsnetz und einer Vielzahl von Werten einer Impedanz eines Erdschlusses entsprechen;
wobei der elektronische Datenprozessor ferner so konfiguriert ist, dass er die Erdschlussstelle und den Wert der Impedanz des Erdschlusses ausgibt, der dem Signatursignal aus der Vielzahl von Signatursignalen entspricht, das die größte Korrelation mit dem erfassten Signal aufweist.

5. Vorrichtung nach einem der vorangehenden Ansprüche, wobei die Vielzahl von Zeitbereichs-, Spannungs- bzw. Stromsignatursignalen Signatursignale umfasst, die durch vorheriges Simulieren des genannten elektrischen Verteilungsnetzes oder durch Simulieren eines Teils des genannten elektrischen Verteilungsnetzes erhalten wurden.

6. Vorrichtung nach einem der vorangehenden Ansprüche, bei der die Vielzahl von Zeitbereichs-, Spannungs- bzw. Stromsignatursignalen Signatursignale umfasst, die durch Simulation des genannten elektrischen Verteilungsnetzes oder eines Teils des genannten elektrischen Verteilungsnetzes erhalten werden, wobei die Simulation durch das Fehlersignal des Erdschlusses ausgelöst wird.

7. Vorrichtung nach einem der vorangehenden Ansprüche, bei der die Vielzahl der Zeitbereichs-, Spannungs- bzw. Stromsignatursignalen Signatursignale umfasst, die durch vorheriges Erfassen aufgetretener Erdschlüsse des genannten elektrischen Verteilungsnetzes, insbesondere versuchsweise induzierter oder natürlich auftretender Erdschlüsse, erhalten wurden.

8. Vorrichtung nach einem der vorangehenden Ansprüche, bei der die Vielzahl von im Voraus festgelegten Stellen in dem genannten elektrischen Verteilungsnetz entsprechend den elektrischen Verteilungsnetzknoten vorbestimmt ist, oder bei der die Vielzahl von im Voraus festgelegten Stellen in dem genannten elektrischen Verteilungsnetz entsprechend im gleichen Abstand zueinander befindlichen elektrischen Stellen im Verteilungsnetz vorbestimmt ist, oder bei der die Vielzahl von im Voraus festgelegten Stellen in dem genannten elektrischen Verteilungsnetz nach im Voraus zufällig festgelegten Stellen im elektrischen Verteilungsnetz vorbestimmt ist.

9. Vorrichtung nach einem der vorangehenden Ansprüche, bei der das in dem Zeitbereich erfasste Spannungs- oder Stromsignal in dem Zeitbereich neu skaliert wird, insbesondere so, dass die Phase des erfassten Signals mit der Phase der Signatursignale der Datenbank übereinstimmt.

10. Vorrichtung nach einem der vorangehenden Ansprüche, wobei der auf den Erdschluss folgende Zeitbereich eine Dauer von 0 - 25 ms, insbesondere von 0 - 10 ms, ferner insbesondere von 0 - 5 ms, ferner insbesondere von 0 - 2 ms, ferner insbesondere von 0 - 1 ms hat, und/oder wobei die genannte Erfassung und Korrelation des Zeitbereichs mit einer Auflösung von mindestens 1 ms, insbesondere mit einer Auflösung von mindestens 0,1 ms erfolgt.

11. Vorrichtung nach einem der vorangehenden Ansprüche, bei der die Korrelation eine anhand des Zeitbereichs berechnete Korrelation ist, insbesondere anhand einer Ähnlichkeitsberechnung des Zeitbereichs oder mit Hilfe eines maschinell lernenden Algorithmus, ferner insbesondere anhand einer quadratischen Differenz oder mit Hilfe eines künstlichen neuronalen Netzes.

12. Vorrichtung nach einem der vorangehenden Ansprüche, wobei die Zeitbereichssignale Spannungssignale sind.

13. Verfahren zur Erdschlussortung in einem kompensiert betriebenen elektrischen Verteilungsnetz mit einem elektronischen Datenprozessor, der so konfiguriert ist, um:

auf das Auftreten eines Fehlersignals eines Erdschlusses, das einen Erdschluss anzeigt, zu warten;
ein in einem Zeitbereich erfasstes Spannungs- oder Stromsignal zu empfangen, wobei der genannte Zeitbereich einen auf den Erdschluss folgenden Zeitraum umfasst;
eine Korrelation zwischen dem im Zeitbereich erfassten genannten Signal und einer Datenbank mit einer Vielzahl von Zeitbereichs-, Spannungs- bzw. Stromsignatursignalen zu berechnen, wobei jedes Signatursignal ein Zeitbereichssignal ist, das einer Erdschlussstelle in einer Vielzahl von im Voraus bestimmten Stellen in dem elektrischen Verteilungsnetz entspricht;

den Ort der Erdschlussstelle auszugeben, die dem Signatursignal aus der Vielzahl der Signatursignale entspricht, das die größte Korrelation mit dem erfassten Signal aufweist;
**dadurch gekennzeichnet, dass** das im Zeitbereich erfasste Spannungs- oder Stromsignal an nur einem Betriebsort des elektrischen Verteilungsnetzes erfasst wird; und dass der Betriebsort des elektrischen Verteilungsnetzes eine Unterstation des genannten elektrischen Verteilungsnetzes ist, wobei sich die Unterstation an dem Ort befindet, an dem das im Zeitbereich erfasste Spannungs- oder Stromsignal erfasst wird.

14. Verfahren nach den vorangehenden Ansprüchen, bei dem das im Zeitbereich erfasste Spannungs- oder Stromsignal im Zeitbereich neu skaliert wird, insbesondere so, dass die Phase des erfassten Signals mit der Phase der Signatursignale der Datenbank übereinstimmt.

15. Nichtflüchtiges Speichermedium, einschließlich Programmanweisungen zur Implementierung eines Verfahrens zur Ortung von Erdschlüssen in einem elektrischen Verteilungsnetz, wobei die Programmanweisungen Anweisungen enthalten, die, wenn sie von einem Prozessor ausgeführt werden, den Prozessor veranlassen, das Verfahren nach den Ansprüchen 13 oder 14 auszuführen.

**Revendications**

1. Dispositif permettant de localiser des défauts à la terre dans un réseau de distribution électrique compensé comprenant un processeur de données électronique configuré pour :

attendre un signal de détection de défaut à la terre selon lequel un défaut à la terre a eu lieu ;
obtenir un signal de tension ou de courant capturé dans un domaine temporel dans lequel ledit domaine temporel comprend une période de temps qui suit ledit défaut à la terre ;
calculer la corrélation dudit signal capturé dans un domaine temporel avec une base de données comprenant une pluralité de signaux de signature de domaine temporel, respectivement de tension ou de courant, dans lequel chaque signal de signature est un signal de domaine temporel correspondant à une localisation de défaut à la terre à partir d'une pluralité de localisations prédéterminées dans ledit réseau de distribution électrique ;
transmettre la localisation de défaut à la terre correspondant au signal de signature de ladite pluralité de signaux de signature qui a la plus haute corrélation avec le signal capturé ;
**caractérisé en ce que** le signal de tension ou de courant capturé dans le domaine temporel est obtenu dans seulement une des localisations opérationnelles du réseau de distribution électrique ; **et en ce que** la localisation opérationnelle du réseau de distribution électrique est une sous-station dudit réseau de distribution électrique, la sous-station se situant où le signal de tension ou de courant capturé dans le domaine temporel est capturé.

2. Dispositif selon la revendication précédente dans lequel le signal de tension ou de courant capturé dans le domaine temporel est un signal capturé passivement, en particulier capturé passivement tel que la compensation du réseau de distribution électrique compensé soit maintenue.

3. Dispositif selon l'une quelconque des revendications précédentes comprenant la transmission de la localisation du défaut à la terre correspondant à une localisation pondérée calculée à partir de deux signaux de signature de ladite pluralité de signaux de signature qui ont les deux plus hautes corrélations calculées avec le signal capturé, dans lequel la pondération de la localisation se fait par les corrélations calculées.

4. Dispositif selon l'une quelconque des revendications précédentes dans lequel ladite base de données comprend une pluralité de signaux de signature, respectivement de tension ou de courant, du domaine temporel, dans lequel chaque signal de signature est un signal de domaine temporel correspondant à une localisation de défaut à la terre et une valeur d'impédance de défaut à la terre correspondant à une pluralité de localisations prédéterminées dans ledit réseau de distribution électrique et une pluralité de valeurs d'impédance de défaut à la terre ;
dans lequel le processeur de données électronique est également configuré pour transmettre la localisation de défaut à la terre et la valeur d'impédance de défaut à la terre correspondant au signal de signature de ladite pluralité de signaux de signature qui a la plus haute corrélation avec le signal capturé.

5. Dispositif selon l'une quelconque des revendications précédentes dans lequel la pluralité de signaux de signature, respectivement de tension ou de courant, du domaine temporel, comprend des signaux de signature obtenus en simulant préalablement ledit réseau de distribution électrique ou en simulant une partie dudit réseau de distribution électrique.

**6.** Dispositif selon l'une quelconque des revendications précédentes dans lequel la pluralité de signaux de signature, respectivement de tension ou de courant, du domaine temporel, comprend des signaux de signature obtenus en simulant ledit réseau de distribution électrique ou une partie dudit réseau de distribution électrique, dans lequel la simulation est déclenchée par le signal de détection de défaut à la terre.

**7.** Dispositif selon l'une quelconque des revendications précédentes dans lequel la pluralité de signaux de signature, respectivement de tension ou de courant, du domaine temporel, comprend des signaux de signature obtenus en capturant préalablement des défauts à la terre dudit réseau de distribution électrique ayant déjà eu lieu, en particulier des défauts à la terre provoqués expérimentalement ou qui ont eu lieu naturellement.

**8.** Dispositif selon l'une quelconque des revendications précédentes dans lequel la pluralité de localisations prédéterminées dans ledit circuit de distribution électrique est prédéterminée selon les noeuds du réseau de distribution électrique, ou dans lequel la pluralité de localisations prédéterminées dans ledit réseau de distribution électrique est prédéterminée selon des localisations de réseau de distribution électrique également distantes, ou dans lequel la pluralité de localisations prédéterminées dans ledit réseau de distribution électrique est prédéterminée selon des localisations de réseau de distribution électrique déterminées aléatoirement.

**9.** Dispositif selon l'une quelconque des revendications précédentes dans lequel le signal de tension ou de courant capturé dans le domaine temporel est rééchelonné dans le domaine temporel, en particulier tel que la phase du signal capturé correspond à la phase des signaux de signature de la base de données.

**10.** Dispositif selon l'une quelconque des revendications précédentes dans lequel ledit domaine temporel a une durée d'émission de défaut à la terre de 0 - 25 ms, en particulier de 0 - 10 ms, plus particulièrement de 0 - 5 ms, plus particulièrement de 0 - 2 ms, plus particulièrement de 0 - 1 ms, et/ou dans lequel ladite capture et corrélation de domaine temporel est exécutée avec une résolution minimale de 1 ms, en particulier une résolution minimale de 0.1 ms.

**11.** Dispositif selon l'une quelconque des revendications précédentes dans lequel la correlation est une corrélation de domaine temporel calculée, en particulier un calcul de similarité de domaine temporel ou à l'aide de un algorithme d'apprentissage automatique, plus particulièrement un calcul de différence carrée ou par un réseau artificiel neuronal.

**12.** Dispositif selon l'une quelconque des revendications précédentes dans lequel les signaux de domaine temporel sont des signaux de tension.

**13.** Procédé pour localiser des défauts à la terre dans un réseau de distribution électrique compensé comprenant un processeur de données électronique exécutant les étapes de :

attendre un signal de détection de défaut à la terre selon lequel un défaut à la terre a eu lieu ;
obtenir un signal de tension ou de courant capturé dans un domaine temporel dans lequel ledit domaine temporel comprend une période de temps qui suit ledit défaut à la terre ;
calculer la corrélation dudit signal capturé dans un domaine temporel avec une base de données comprenant une pluralité de signaux de signature de domaine temporel, respectivement de tension ou de courant, dans lequel chaque signal de signature est un signal de domaine temporel correspondant à une localisation de défaut à la terre à partir d'une pluralité de localisations prédéterminées dans ledit réseau de distribution électrique ;
transmettre la localisation de défaut à la terre correspondant au signal de signature de ladite pluralité de signaux de signature qui a la plus haute corrélation avec le signal capturé ;
**caractérisé en ce que** le signal de tension ou de courant capturé dans le domaine temporel est obtenu dans seulement une des localisations opérationnelles du réseau de distribution électrique ; **et en ce que** la localisation opérationnelle du réseau de distribution électrique est une sous-station dudit réseau de distribution électrique, la sous-station se situant où le signal de tension ou de courant capturé dans le domaine temporel est capturé.

**14.** Procédé selon l'une quelconque des revendications précédentes dans lequel le signal de tension ou de courant capturé dans le domaine temporel est rééchelonné dans le domaine temporel, en particulier tel que la phase du signal capturé corresponde à la phase des signaux de signature de la base de données.

**15.** Moyen de stockage non transitoire incluant les instructions de programme pour mettre en place un procédé permettant de localiser des défauts à la terre dans un réseau de distribution électrique, les instructions de programme incluant des instructions qui, lorsqu'elles sont exécutées par un processeur, mènent le processeur à exécuter le procédé des revendications 13 ou 14.

**Fig. 1**

110 kV

Petersen Coil

30 kV

Load

Load        Load

Load        Load        Load

Load        Load

Load

Load

Load

Load

**Fig. 2**

**Fig. 3**

**Fig. 4**

Fig. 5

Fig. 6

Fig. 7

Fig. 8

Fig. 9

Fig. 10

Fig. 11

**Fig. 12**

**EP 3 553 541 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2016041216 A1